# EUROPEAN PATENT APPLICATION

(11) **EP 3 503 210 A1**
(43) Date of publication of application: **26.06.2019**
(21) Application number: 18192101.6
(22) Date of filing: 31.08.2018
(51) Int. Cl.: H01L 31/0224, H01L 31/0747, H01L 31/18

(54) **HETEROJUNCTION SOLAR CELL AND FABRICATION METHOD THEREOF**

(30) Priority: 21.12.2017 CN 201711397697
(71) Applicant: Beijing Juntai Innovation Technology Co., Ltd, 100176 Beijing (CN)
(72) Inventor: DONG, Gangqiang, BEIJING, 100176 (CN)
(74) Representative: Cabinet Beau de Loménie

(57) **Abstract**

Provided is a heterojunction solar cell, which sequentially comprises, from top to bottom, a first electrode (10), a first watered ITO transparent conductive layer (8), a first amorphous silicon doped layer (3), a first intrinsic amorphous silicon passivated layer (2), a monocrystalline silicon wafer (1), a second intrinsic amorphous silicon passivated layer (4), a second amorphous silicon doped layer (5), a second watered ITO transparent conductive layer (8') and a second electrode (10'). The present application further provides a method for fabricating the above heterojunction solar cell.

## Description

### Technical Field

The present application relates to, without limitations, the technical field of solar cells, and more particularly, but without limitations, to a heterojunction solar cell and a fabrication method thereof.

### Background

In the field of solar heterojunction cells, indium tin oxide (ITO for short) films are of great importance, which are responsible for allowing most sunlight into the cell smoothly while collecting photon-generated carriers. This requires that the ITO films satisfy the following three conditions simultaneously: a high transmittance; a good electric conductivity; and a good light trapping effect.

### Summary of the Application

Provided below is a brief summary of the subject matter described herein in detail. This brief summary is not intended to limit the scope of protection of the claims. The present application provides a heterojunction solar cell, which sequentially comprises a first electrode, a first watered transparent conductive layer, a first silicon doped layer, a first intrinsic silicon passivated layer, a silicon wafer, a second intrinsic silicon passivated layer, a second silicon doped layer, a second watered transparent conductive layer and a second electrode in a top-down manner.

The present application further provides a method for fabricating the heterojunction solar cell, which comprises the following steps of:
sequentially depositing a first intrinsic silicon passivated layer and a first silicon doped layer onto a first surface of a silicon wafer, and sequentially depositing a second intrinsic silicon passivated layer and a second silicon doped layer on a second surface of the silicon wafer;
depositing a first watered transparent conductive layer onto the first silicon doped layer;
depositing a second watered transparent conductive layer onto the second silicon doped layer;
respectively screen-printing a first electrode and a second electrode on the first watered transparent conductive layer and the second watered transparent conductive layer.

### Brief Description of the Drawings

The accompanying drawings are included to provide a further understanding of the technical solution set forth in the present application, and constitute part of the description. They serve to explain the technical solution set forth in the present application along with the embodiments of the present application, but do not constitute limitations thereon.
Figure 1 is a structural schematic view of a heterojunction solar cell of Embodiment 1 and 2 of the present application.
Figure 2(a) is a comparison diagram of transmittance spectra of ordinary ITO, watered ITO and laminated ITO prepared in Embodiment 1 of the present application.
Figure 2(b) is a partial enlarged diagram of the transmittance spectra of Figure 2(a).
Figure 2(c) is another partial enlarged diagram of the transmittance spectra of Figure 2(a).

### Detailed Description of the Application

To make the object, technical solution and advantages of the present application clearer, the embodiments of the present application will be described below in detail in conjunction with the accompanying drawings. It should be noted that the embodiments in the present application and features therein may be arbitrarily combined with one another without conflict.

In the studying process of silicon-based heterojunction solar cells, the inventor of the present application discovers in depth that the prior ITO film and preparation method thereof have some problems, which are summarized as follows:
Generally, the transmittance and the electric conductivity of the ITO film are contradicted. The increase in the electric conductivity is often dependent on the increase in the concentration of carriers within the ITO material; however, blindly pursuing the increase in the concentration of carriers would lead to a decrease in the transmittance. In order to improve the electric conductivity of the ITO material while keeping the transmittance thereof unaffected (namely, without increasing the carrier concentration thereof), the only option is to improve the migration rate. Both the electric conductivity and the transmittance of ITO can be increased by improving the migration rate of the material (the carrier concentration remains unchanged). However, in the process of experiments, the inventor of the present application discovers that there is a severe contact problem between the ITO material having such a high migration rate (good electric conductivity and high transmittance) and the amorphous silicon layer and screen-printed silver grid lines of the cell.

As for the preparation of ITO, after the amorphous silicon layer is deposited, the cell would be adversely affected by a high-temperature annealing process of either excessively high temperature or excessively long time. As shown by many experiments, the ITO film deposited under low-temperature conditions is a microcrystalline film. Despite its high carrier concentration, low migration rate and poor transmittance, such a microcrystalline film exhibits a good contact with the doped amorphous silicon and screen-printed silver grids. If only the microcrystalline film is used as the transparent conductive layer of the cell, the cell exhibits a good contact; however, as a result of low transmittance and other factors, the short-circuit current of the cell is generally on the low side.

As further discovered by the inventor of the present application, in the preparation process of amorphous ITO, a certain amount of water vapor may be introduced into the reaction to improve the performance of the prepared watered ITO transparent conductive layer (in the present application, the ITO transparent conductive layer prepared by the watering process is defined as a watered ITO transparent conductive layer, and the ITO transparent conductive layer prepared by the prior non-watering process is defined as a non-watered ITO transparent conductive layer), thereby obtaining a watered ITO transparent conductive layer having a high migration rate and a low carrier concentration. The watered ITO transparent conductive layer exhibits a good light transmittance, but there are many problems between this layer and the doped amorphous silicon layer and screen-printed silver grids of the cell, such as matching of work functions and electrode contact. If only the watered ITO transparent conductive layer is used as the transparent conductive layer of the cell, the cell exhibits a good short-circuit current, but its open-circuit voltage and filling factors are on the low side.

After extensive research, the inventor of the present application creatively proposes an design: ITO conductive layers are prepared on the front and rear sides of the cell using different processes. ITO films are required to be deposited onto the front and rear sides of the solar cell. Most R&D organizations and manufacturers only utilize a single process (e.g., one of the conventional process, the hydrogen-doping process, the high-temperature process, etc) to deposit ITO onto the front and rear sides of the cell. Such a practice may minimize the complexity of the process, but the efficiency of the cell is affected.

The present application provides a heterojunction solar cell fabricated using a watered ITO transparent conductive layer, and preparation method thereof, which effectively solves such problems as poor contact of the ITO conductive layer with the doped amorphous silicon and screen-printed silver grids as well as low transmittance. Specifically, the present application provides a heterojunction solar cell, which contains a first electrode, a first watered transparent conductive layer, a first silicon doped layer, a first intrinsic silicon passivated layer, a silicon wafer, a second intrinsic silicon passivated layer, a second silicon doped layer, a second watered transparent conductive layer and a second electrode that are sequentially arranged in a top-down manner.

In some embodiments, the first watered transparent conductive layer is a first watered ITO transparent conductive layer or a first watered AZO transparent conductive layer. Alternatively, the first silicon doped layer is a first amorphous silicon doped layer or a first microcrystalline silicon doped layer. Alternatively, the first intrinsic silicon passivated layer is a first intrinsic amorphous silicon passivated layer or a first intrinsic microcrystalline silicon passivated layer. Alternatively, the silicon wafer is a monocrystalline silicon wafer or a polycrystalline silicon wafer. Alternatively, the second intrinsic silicon passivated layer is a second intrinsic amorphous silicon passivated layer or a second intrinsic microcrystalline silicon passivated layer. Alternatively, the second silicon doped layer is a second amorphous silicon doped layer or a second microcrystalline silicon doped layer. Alternatively, the second watered transparent conductive layer is a second watered ITO transparent conductive layer or a second watered AZO transparent conductive layer.

In some embodiments, the heterojunction solar cell sequentially contains, from top to bottom, a first electrode, a first watered ITO transparent conductive layer, a first amorphous silicon doped layer, a first intrinsic amorphous silicon passivated layer, a monocrystalline silicon wafer, a second intrinsic amorphous silicon passivated layer, a second amorphous silicon doped layer, a second watered ITO transparent conductive layer and a second electrode.

In some embodiments, the first watered ITO transparent conductive layer and the second watered ITO transparent conductive layer may each have a thickness of 50nm to 110 nm.

In some embodiments, the heterojunction solar cell may also contain a non-watered transparent conductive layer, wherein the non-watered transparent conductive layer contains a first non-watered layer and a second non-watered layer;
the first non-watered layer is disposed between the first silicon doped layer and the first watered transparent conductive layer;
the second non-watered layer is disposed between the second silicon doped layer and the second watered transparent conductive layer.

In some embodiments, the non-watered transparent conductive layer is a non-watered ITO transparent conductive layer or a non-watered AZO transparent conductive layer.

In some embodiments, the non-watered transparent conductive layer is a non-watered ITO transparent conductive layer containing a first non-watered ITO layer and a second non-watered ITO layer;
the first non-watered ITO layer is disposed between the first amorphous silicon doped layer and the first watered ITO transparent conductive layer;
the second non-watered ITO layer is disposed between the second amorphous silicon doped layer and the second watered ITO transparent conductive layer.

In some embodiments, the non-watered transparent conductive layer further contains a third non-watered layer and a fourth non-watered layer;
the third non-watered layer is disposed between the first watered transparent conductive layer and the first electrode;
the fourth non-watered layer is disposed between the second watered transparent conductive layer and the second electrode.

In some embodiments, the third non-watered layer is a third non-watered ITO layer or a third non-watered AZO layer.

Alternatively,
the fourth non-watered layer is a fourth non-watered ITO layer or a fourth non-watered AZO layer.

In some embodiments, the third non-watered layer is the third non-watered ITO layer, and the fourth non-watered layer is the fourth non-watered ITO layer;
the third non-watered ITO layer is disposed between the first watered ITO transparent conductive layer and the first electrode;
the fourth non-watered ITO layer is disposed between the second watered ITO transparent conductive layer and the second electrode.

In some embodiments, the first non-watered ITO layer and the second non-watered ITO layer may each have a thickness of 5nm to 10 nm.

In some embodiments, the first non-watered ITO layer may have a square resistance of 20Ω/□ (20Ω per square) to 80 Ω/□, and the second non-watered ITO layer may have a square resistance of 130Ω/□ to 200 Q/□.

In some embodiments, the first non-watered ITO layer may have a square resistance of 130Ω/□ to 200 Q/□, and the second non-watered ITO layer may have a square resistance of 20Ω/□. to 80 Q/□.

In some embodiments, the third non-watered ITO layer and the fourth non-watered ITO layer may each have a thickness of 5nm to 10 nm and a square resistance of 20Ω/□. to 80 Ω/□.

In some embodiments, the monocrystalline silicon wafer may be an N-type monocrystalline silicon wafer, which may have a thickness of 50µm to 300 µm.

In some embodiments, the first intrinsic amorphous silicon passivated layer and the second intrinsic amorphous silicon passivated layer may each have a thickness of 1nm to 20 nm.

In some embodiments, the first amorphous silicon doped layer and the second amorphous silicon doped layer may each have a thickness of 3nm to 20 nm.

In some embodiments, the first amorphous silicon doped layer may be a P-type amorphous silicon doped layer, and the second amorphous silicon doped layer may be an N-type amorphous silicon doped layer.

In some embodiments, the first amorphous silicon doped layer may be an N-type amorphous silicon doped layer, and the second amorphous silicon doped layer may be a P-type amorphous silicon doped layer.

The present application further provides a method for fabricating the heterojunction solar cell, which contains the following steps of:
sequentially depositing a first intrinsic silicon passivated layer and a first silicon doped layer onto a first surface of a silicon wafer, and sequentially depositing a second intrinsic silicon passivated layer and a second silicon doped layer on a second surface of the silicon wafer;
depositing a first watered transparent conductive layer onto the first silicon doped layer;
depositing a second watered transparent conductive layer onto the second silicon doped layer;
respectively screen-printing a first electrode and a second electrode on the first watered transparent conductive layer and the second watered transparent conductive layer.

In some embodiments, the first watered transparent conductive layer is a first watered ITO transparent conductive layer or a first watered AZO transparent conductive layer.

Alternatively,
the first silicon doped layer is a first amorphous silicon doped layer or a first microcrystalline silicon doped layer.

Alternatively,
the first intrinsic silicon passivated layer is a first intrinsic amorphous silicon passivated layer or a first intrinsic microcrystalline silicon passivated layer. Alternatively,
the silicon wafer is a monocrystalline silicon wafer or a polycrystalline silicon wafer. Alternatively,
the second intrinsic silicon passivated layer is a second intrinsic amorphous silicon passivated layer or a second intrinsic microcrystalline silicon passivated layer. Alternatively,
the second silicon doped layer is a second amorphous silicon doped layer or a second microcrystalline silicon doped layer.

Alternatively,
the second watered transparent conductive layer is a second watered ITO transparent conductive layer or a second watered AZO transparent conductive layer. In some embodiments, a first intrinsic amorphous silicon passivated layer and a first amorphous silicon doped layer are deposited sequentially onto the first surface of a monocrystalline silicon wafer, and a second intrinsic amorphous silicon passivated layer and a second amorphous silicon doped layer are deposited sequentially onto the second surface of the monocrystalline silicon wafer;
a first watered ITO transparent conductive layer is deposited onto the first amorphous silicon doped layer;
a second watered ITO transparent conductive layer is deposited onto the second amorphous silicon doped layer;
a first electrode and a second electrode are respectively screen-printed on the first watered ITO transparent conductive layer and the second watered ITO transparent conductive layer.

In some embodiments, after depositing the first amorphous silicon doped layer onto the first intrinsic amorphous silicon passivated layer, and before depositing the first watered ITO transparent conductive layer onto the first amorphous silicon doped layer, the method further contains a step of: depositing a first non-watered ITO layer onto the first amorphous silicon doped layer, and then depositing the first watered ITO transparent conductive layer onto the first non-watered ITO layer.

In some embodiments, after depositing the second amorphous silicon doped layer onto the second intrinsic amorphous silicon passivated layer, and before depositing the second watered ITO transparent conductive layer onto the second amorphous silicon doped layer, the method further contains a step of: depositing a second non-watered ITO layer onto the second amorphous silicon doped layer, and then depositing the second watered ITO transparent conductive layer onto the second non-watered ITO layer.

In some embodiments, after depositing the first watered ITO transparent conductive layer, and before screen-printing the first electrode, the method further contains a step of: depositing a third non-watered ITO layer onto the first watered ITO transparent conductive layer, and then screen-printing the first electrode on the third non-watered ITO layer.

In some embodiments, after depositing the second watered ITO transparent conductive layer, and before screen-printing the second electrode, the method further contains a step of: depositing a fourth non-watered ITO layer onto the second watered ITO transparent conductive layer, and then screen-printing the second electrode on the fourth non-watered ITO layer.

In some embodiments, the step of depositing the first watered ITO transparent conductive layer or the second watered ITO transparent conductive layer may contain: argon, oxygen and water vapor are introduced at room temperature to deposit the watered ITO transparent conductive layer.

In some embodiments, the flow of the water vapor may be kept constant at 0.5 seem to 25 seem in the deposition process of the first watered ITO transparent conductive layer or the second watered ITO transparent conductive layer.

In some embodiments, a magnetron sputtering process may be used for the coating deposition of the first watered ITO transparent conductive layer or the second watered ITO transparent conductive layer.

Optionally,
the gas flow ratio of the argon, the oxygen to the water vapor may ranges from 200:10:1 to 400:10:1;
the pressure may be 0.1 Pa to 1 Pa during deposition, and the power density of the sputtering power source may be 0.5 W/cm² to 3 W/cm².

In some embodiments, the first watered ITO transparent conductive layer and the second watered ITO transparent conductive layer may each have a thickness of 50nm to 110 nm.

In some embodiments, the step of depositing a first non-watered ITO layer onto the first amorphous silicon doped layer may contain: argon and oxygen are introduced at room temperature, and the first non-watered ITO layer is deposited onto the first amorphous silicon doped layer using the magnetron sputtering process.

Optionally,
the gas flow ratio of the argon to the oxygen may be 20:1 to 60:1;
the pressure may be 0.1 Pa to 2 Pa during deposition, and the power density of the sputtering power source may be 0.5 W/cm² to 3 W/cm².

In some embodiments, the first non-watered ITO layer may have a thickness of 5nm to 10 nm and a square resistance of 20Ω/□. to 80 Ω/□.

In some embodiments, the step of depositing a second non-watered ITO layer onto the second amorphous silicon doped layer may contain: argon and oxygen are introduced at room temperature, and the second non-watered ITO layer is deposited onto the second amorphous silicon doped layer using the magnetron sputtering process.

Optionally,
the gas flow ratio of the argon to the oxygen may be 10:1 to 30:1;
the pressure may be 0.1 Pa to 2 Pa during deposition, and the power density of the sputtering power source may be 0.5 W/cm² to 3 W/cm².

In some embodiments, the second non-watered ITO layer may have a thickness of 5nm to 10 nm and a square resistance of 130Ω/□ to 200Ω/□.

In some embodiments, the step of depositing a third non-watered ITO layer or a fourth non-watered ITO layer onto the first watered ITO transparent conductive layer or the second watered ITO transparent conductive layer may contain: argon and oxygen are introduced at room temperature, and the third non-watered ITO layer or the fourth non-watered ITO layer is deposited onto the first watered ITO transparent conductive layer or the second watered ITO transparent conductive layer using the magnetron sputtering process.

Optionally,
the gas flow ratio of the argon to the oxygen may be 20:1to 60:1;
the pressure may be 0.1Pa to 2Pa during deposition, and the power density of the sputtering power source may be 0.5 W/cm² to 3 W/cm².

In some embodiments, the third non-watered ITO layer and the fourth non-watered ITO layer may each have a thickness of 5nm to 10 nm and a square resistance of 20Ω/□ to 80 Ω/□.

In some embodiments, the monocrystalline silicon wafer may be an N-type monocrystalline silicon wafer, which may have a thickness of 50µm to 300 µm.

In some embodiments, the first intrinsic amorphous silicon passivated layer and the second intrinsic amorphous silicon passivated layer may each have a thickness of 1 nm to 20 nm.

In some embodiments, the first amorphous silicon doped layer and the second amorphous silicon doped layer may each have a thickness of 3 nm to 20 nm.

In some embodiments, the first amorphous silicon doped layer may be a P-type amorphous silicon doped layer, and the second amorphous silicon doped layer may be an N-type amorphous silicon doped layer.

In some embodiments, the first amorphous silicon doped layer may be an N-type amorphous silicon doped layer, and the second amorphous silicon doped layer may be a P-type amorphous silicon doped layer.

In some embodiments, the first intrinsic amorphous silicon passivated layer, the first amorphous silicon doped layer, the second intrinsic amorphous silicon passivated layer and the second amorphous silicon doped layer may be deposited using the chemical vapor deposition process.

In the heterojunction solar cell provided by the present application, the advantages of the ordinary non-watered ITO transparent conductive layer are combined with those of the watered ITO transparent conductive layer. Meanwhile, the matching problem of work functions between the ITO transparent conductive layer and the amorphous silicon layer is taken into consideration from the perspective of physical principles, and the problem of poor contact of the watered ITO transparent conductive layer with the doped amorphous silicon and the screen-printed silver grid is effectively solved, thereby exhibiting excellent photoelectric performance.

Other features and advantages of the present application will be described in the following description, and will be partially apparent from the description or understood through implementation of the present application. The objects and other advantages of the present application may be achieved and obtained through the structure particularly pointed out in the description, the claims and the accompanying drawings.

It should be noted that the material of the first watered transparent conductive layer is not specifically defined in the present application, wherein the first watered transparent conductive layer may be a first watered ITO transparent conductive layer or a first watered AZO transparent conductive layer, and further, it may be the first watered ITO transparent conductive layer. The material of the first silicon doped layer is not specifically defined in the present application, wherein the first silicon doped layer may be a first amorphous silicon doped layer or a first microcrystalline silicon doped layer, and further, it may be the first amorphous silicon doped layer. The material of the first intrinsic silicon passivated layer is not specifically defined in the present application, wherein the first intrinsic silicon passivated layer may be a first intrinsic amorphous silicon passivated layer or a first intrinsic microcrystalline silicon passivated layer, and further, it may be the first intrinsic amorphous silicon passivated layer. The material of the silicon wafer is not specifically defined in the present application, wherein the silicon wafer may be a monocrystalline silicon wafer or a polycrystalline silicon wafer, and further, it may be the monocrystalline silicon wafer. The material of the second intrinsic silicon passivated layer is not specifically defined in the present application, wherein the second intrinsic silicon passivated layer may be a second intrinsic amorphous silicon passivated layer or a second intrinsic microcrystalline silicon passivated layer, and further, it may be the second intrinsic amorphous silicon passivated layer. The material of the second silicon doped layer is not specifically defined in the present application, wherein the second silicon doped layer may be a second amorphous silicon doped layer or a second microcrystalline silicon doped layer, and further, it may be the second amorphous silicon doped layer. The material of the second watered transparent conductive layer is not specifically defined in the present application, wherein the second watered transparent conductive layer may be a second watered ITO transparent conductive layer or a second watered AZO transparent conductive layer, and further, it may be the second watered ITO transparent conductive layer.

It should be noted that the material of the non-watered transparent conductive layer is likewise not specifically defined in the present application, wherein the non-watered transparent conductive layer may be a non-watered ITO transparent conductive layer or a non-watered AZO transparent conductive layer, and further, it may be the non-watered ITO transparent conductive layer.

It should be noted that the material of the foregoing third non-watered layer is not specifically defined in the present application, wherein the third non-watered layer may be a third non-watered ITO layer or a third non-watered AZO layer, and further, it may be the third non-watered ITO layer. Similarly, the material of the foregoing fourth non-watered layer is not specifically defined in the present application, wherein the fourth non-watered layer may be a fourth non-watered ITO layer or a fourth non-watered AZO layer, and further, it may be the fourth non-watered ITO layer. Similarly, the material of the first watered transparent conductive layer in the above fabrication method is not specifically defined in the present application, wherein the first watered transparent conductive layer may be a first watered ITO transparent conductive layer or a first watered AZO transparent conductive layer, and further, it may be the first watered ITO transparent conductive layer. The material of the first silicon doped layer is not specifically defined in the present application, wherein the first silicon doped layer may be a first amorphous silicon doped layer or a first microcrystalline silicon doped layer, and further, it may be the first amorphous silicon doped layer. The material of the first intrinsic silicon passivated layer is not specifically defined in the present application, wherein the first intrinsic silicon passivated layer may be a first intrinsic amorphous silicon passivated layer or a first intrinsic microcrystalline silicon passivated layer, and further, it may be the first intrinsic amorphous silicon passivated layer. The material of the silicon wafer is not specifically defined in the present application, wherein the silicon wafer may be a monocrystalline silicon wafer or a polycrystalline silicon wafer, and further, it may be the monocrystalline silicon wafer. The material of the second intrinsic silicon passivated layer is not specifically defined in the present application, wherein the second intrinsic silicon passivated layer may be a second intrinsic amorphous silicon passivated layer or a second intrinsic microcrystalline silicon passivated layer, and further, it may be the second intrinsic amorphous silicon passivated layer. The material of the second silicon doped layer is not specifically defined in the present application, wherein the second silicon doped layer may be a second amorphous silicon doped layer or a second microcrystalline silicon doped layer, and further, it may be the second amorphous silicon doped layer. The material of the second watered transparent conductive layer is not specifically defined in the present application, wherein the second watered transparent conductive layer may be a second watered ITO transparent conductive layer or a second watered AZO transparent conductive layer, and further, it may be the second watered ITO transparent conductive layer.

### Embodiment 1

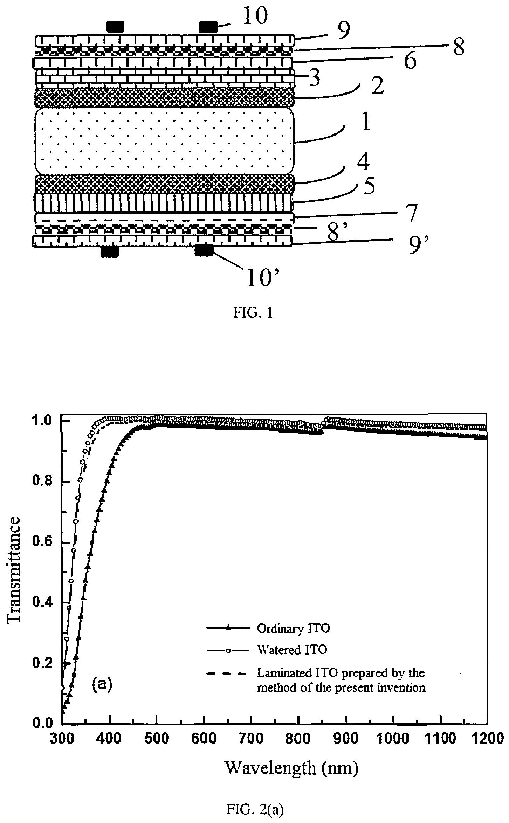

The heterojunction solar cell in this embodiment is an SHJ heterojunction cell. Referring to Figure 1, the SHJ heterojunction cell includes, from top to bottom, a first electrode (10), a third non-watered ITO layer (9), a first watered ITO transparent conductive layer (8), a first non-watered ITO layer (6), a phosphorus doped a-Si:H(n) layer (3), a first intrinsic amorphous silicon passivated layer (2), an N-type monocrystalline silicon wafer (1), a second intrinsic amorphous silicon passivated layer (4), a boron doped a-Si:H(p) layer (5), a second non-watered ITO layer (7), a second watered ITO transparent conductive layer (8'), a fourth non-watered ITO layer (9') and a second electrode (10').

The N-type monocrystalline silicon wafer (1) has a thickness of 200 µm;
the first intrinsic amorphous silicon passivated layer (2) has a thickness of 10 nm; the second intrinsic amorphous silicon passivated layer (4) has a thickness of 10 nm; the phosphorus doped a-Si:H(n) layer (3) has a thickness of 15 nm;
the boron doped a-Si:H(p) layer (5) has a thickness of 15 nm;
the first watered ITO transparent conductive layer (8) has a thickness of 50 nm;
the second watered ITO transparent conductive layer (8') has a thickness of 50 nm; the first non-watered ITO layer (6) has a thickness of 8 nm and a square resistance of 70 Ω/□;
the second non-watered ITO layer (7) has a thickness of 7 nm and a square resistance of 180 Ω/□;
the third non-watered ITO layer (9) has a thickness of 7 nm and a square resistance of 80 Ω/□;
the fourth non-watered ITO layer (9') has a thickness of 7 nm and a square resistance of 80 Ω/□.

Here, the combination of the first non-watered ITO layer (6), the first watered ITO transparent conductive layer (8) and the third non-watered ITO layer (9), or the combination of the second non-watered ITO layer (7), the second watered ITO transparent conductive layer (8') and the fourth non-watered ITO layer (9') may be referred to as laminated ITO.

The SHJ heterojunction cell of this embodiment is fabricated using the method containing the following steps:
a chemical vapor deposition process is utilized to sequentially deposit a first intrinsic amorphous silicon passivated layer (2) and a phosphorus doped a-Si:H(n) layer (3) onto a first surface of an N-type monocrystalline silicon wafer (1), and to sequentially deposit a second intrinsic amorphous silicon passivated layer (4) and a boron doped a-Si:H(p) layer (5) onto a second surface of the N-type monocrystalline silicon wafer (1);
   wherein the first intrinsic amorphous silicon passivated layer (2) or the second intrinsic amorphous silicon passivated layer (4) is deposited under the following conditions: the power of the power source is 350 W, the gas flow ratio of hydrogen to silane (hydrogen dilution ratio) is 12:1, the pressure intensity is 0.7 Pa, and the substrate temperature is 240 DEG C during deposition; the phosphorus doped a-Si:H(n) layer (3) is deposited under the following conditions: the power of the power source is 400 W, the gas flow ratio of hydrogen to silane (hydrogen dilution ratio) is 4:1, the gas flow ratio of phosphane to silane (phosphorus-silicon ratio) is 1:100, the pressure intensity is 0.4 Pa, and the substrate temperature is 230 DEG C during deposition; the boron doped a-Si:H(p) layer (5) is deposited under the following conditions: the power of the power source is 500 W, the gas flow ratio of hydrogen to silane (hydrogen dilution ratio) is 5:1, the gas flow ratio of phosphane to silane (phosphorus-silicon ratio) is 2:98, the pressure intensity is 0.3 Pa, and the substrate temperature is 200 DEG C during deposition;
b) argon and oxygen are introduced at room temperature, and the gas flow ratio therebetween is set to be 50:1; the pressure intensity within the chamber is maintained at 1.2 Pa; the sputtering power source is turned on, and the power density of the power source is 2 W/cm²; a first non-watered ITO layer (6) is deposited onto the phosphorus doped a-Si:H(n) layer (3) using the magnetron sputtering process;
c) argon, oxygen and water vapor are introduced simultaneously at room temperature, and the gas flow ratio therebetween is set to be 300:10:1; the pressure intensity within the chamber is maintained at 0.8 Pa, and the flow of the water vapor is kept stable at 3 sccm; the sputtering power source is turned on, and the power density of the power source is 2.5 W/cm²; a first watered ITO transparent conductive layer (8) is deposited onto the first non-watered ITO layer (6) using the magnetron sputtering process;
d) argon and oxygen are introduced at room temperature, and the gas flow ratio therebetween is set to be 50:1; the pressure intensity within the chamber is maintained at 1.2 Pa; the sputtering power source is turned on, and the power density of the power source is 2.5 W/cm²; a third non-watered ITO layer (9) is deposited onto the first watered ITO transparent conductive layer (8) using the magnetron sputtering process;
e) argon and oxygen are introduced at room temperature, and the gas flow ratio therebetween is set to be 25:1; the pressure intensity within the chamber is maintained at 1.3 Pa; the sputtering power source is turned on, and the power density of the power source is 2.2 W/cm²; a second non-watered ITO layer (7) is deposited onto the boron doped a-Si:H(p) layer (5) using the magnetron sputtering process;
f) argon, oxygen and water vapor are introduced simultaneously at room temperature, and the gas flow ratio therebetween is set to be 300:10:1; the pressure intensity within the chamber is maintained at 1 Pa, and the flow of the water vapor is kept stable at 3 seem; the sputtering power source is turned on, and the power density of the power source is 2.5 W/cm²; a second watered ITO transparent conductive layer (8') is deposited onto the second non-watered ITO layer (7) using the magnetron sputtering process;
g) argon and oxygen are introduced at room temperature, and the gas flow ratio therebetween is set to be 45:1; the pressure intensity within the chamber is maintained at 1.7 Pa; the sputtering power source is turned on, and the power density of the power source is 2.5 W/cm²; a fourth non-watered ITO layer (9') is deposited onto the second watered ITO transparent conductive layer (8') using the magnetron sputtering process;
h) a first electrode (10) and a second electrode (10') are respectively screen-printed on the third non-watered ITO layer (9) and the fourth non-watered ITO layer (9').

It should be appreciated by those skilled in the art that although the fabrication process of Embodiment 1 is shown in the form of steps a) to f), it is not defined that the heterojunction solar cell of this embodiment must be fabricated according to the order of a) to f). For example, the heterojunction solar cell of this embodiment may also be fabricated according to the following order: a), b), e), c), f), d), g) and h).

### Embodiment 2

The heterojunction solar cell in this embodiment is an SHJ heterojunction cell. Referring to Figure 1, the SHJ heterojunction cell sequentially contains, from top to bottom, a first electrode (10), a third non-watered ITO layer (9), a first watered ITO transparent conductive layer (8), a first non-watered ITO layer (6), a phosphorus doped a-Si:H(n) layer (3), a first intrinsic amorphous silicon passivated layer (2), an N-type monocrystalline silicon wafer (1), a second intrinsic amorphous silicon passivated layer (4), a boron doped a-Si:H(p) layer (5), a second non-watered ITO layer (7), a second watered ITO transparent conductive layer (8'), a fourth non-watered ITO layer (9') and a second electrode (10').

The N-type monocrystalline silicon wafer (1) has a thickness of 150 µm;
the first intrinsic amorphous silicon passivated layer (2) has a thickness of 5 nm;
the second intrinsic amorphous silicon passivated layer (4) has a thickness of 5 nm;
the phosphorus doped a-Si:H(n) layer (3) has a thickness of 12 nm;
the boron doped a-Si:H(p) layer (5) has a thickness of 12 nm;
the first watered ITO transparent conductive layer (8) has a thickness of 110 nm;
the second watered ITO transparent conductive layer (8') has a thickness of 80 nm;
the first non-watered ITO layer (6) has a thickness of 6 nm and a square resistance of 50 Ω/□;
the second non-watered ITO layer (7) has a thickness of 5 nm and a square resistance of 150 Ω/□;
the third non-watered ITO layer (9) has a thickness of 7 nm and a square resistance of 40 Ω/□;
the fourth non-watered ITO layer (9') has a thickness of 7 nm and a square resistance of 40 Ω/□.

The SHJ heterojunction cell of this embodiment is fabricated using the method containing the following steps:
a chemical vapor deposition process is utilized to sequentially deposit a first intrinsic amorphous silicon passivated layer (2) and a phosphorus doped a-Si:H(n) layer (3) onto a first surface of an N-type monocrystalline silicon wafer (1), and to sequentially deposit a second intrinsic amorphous silicon passivated layer (4) and a boron doped a-Si:H(p) layer (5) onto a second surface of the N-type monocrystalline silicon wafer (1);
   wherein the first intrinsic amorphous silicon passivated layer (2) or the second intrinsic amorphous silicon passivated layer (4) is deposited under the following conditions: the power of the power source is 380 W, the gas flow ratio of hydrogen to silane (hydrogen dilution ratio) is 14:1, the pressure intensity is 0.7 Pa, and the substrate temperature is 220 DEG C during deposition; the phosphorus doped a-Si:H(n) layer (3) is deposited under the following conditions: the power of the power source is 400 W, the gas flow ratio of hydrogen to silane (hydrogen dilution ratio) is 4:1, the gas flow ratio of phosphane to silane (phosphorus-silicon ratio) is 1:100, the pressure intensity is 0.6 Pa, and the substrate temperature is 220 DEG C during deposition; the boron doped a-Si:H(p) layer (5) is deposited under the following conditions: the power of the power source is 450 W, the gas flow ratio of hydrogen to silane (hydrogen dilution ratio) is 5:1, the gas flow ratio of phosphane to silane (phosphorus-silicon ratio) is 1:100, the pressure intensity is 0.3 Pa, and the substrate temperature is 200 DEG C during deposition;
b) argon and oxygen are introduced at room temperature, and the gas flow ratio therebetween is set to be 30:1; the pressure intensity within the chamber is maintained at 0.2 Pa; the sputtering power source is turned on, and the power density of the power source is 0.8 W/cm²; a first non-watered ITO layer (6) is deposited onto the phosphorus doped a-Si:H(n) layer (3) using the magnetron sputtering process;
c) argon, oxygen and water vapor are introduced simultaneously at room temperature, and the gas flow ratio therebetween is set to be 250:10:1; the pressure intensity within the chamber is maintained at 0.5 Pa, and the flow of the water vapor is kept stable at 1 seem; the sputtering power source is turned on, and the power density of the power source is 0.8 W/cm²; a first watered ITO transparent conductive layer (8) is deposited onto the first non-watered ITO layer (6) using the magnetron sputtering process;
d) argon and oxygen are introduced at room temperature, and the gas flow ratio therebetween is set to be 30:1; the pressure intensity within the chamber is maintained at 0.5 Pa; the sputtering power source is turned on, and the power density of the power source is 1.1 W/cm²; a third non-watered ITO layer (9) is deposited onto the first watered ITO transparent conductive layer (8) using the magnetron sputtering process;
e) argon and oxygen are introduced at room temperature, and the gas flow ratio therebetween is set to be 12:1; the pressure intensity within the chamber is maintained at 0.4 Pa; the sputtering power source is turned on, and the power density of the power source is 0.6 W/cm²; a second non-watered ITO layer (7) is deposited onto the boron doped a-Si:H(p) layer (5) using the magnetron sputtering process;
f) argon, oxygen and water vapor are introduced simultaneously at room temperature, and the gas flow ratio therebetween is set to be 250:10:1; the pressure intensity within the chamber is maintained at 0.5 Pa, and the flow of the water vapor is kept stable at 1 seem; the sputtering power source is turned on, and the power density of the power source is 0.8 W/cm²; a second watered ITO transparent conductive layer (8') is deposited onto the second non-watered ITO layer (7) using the magnetron sputtering process;
g) argon and oxygen are introduced at room temperature, and the gas flow ratio therebetween is set to be 25:1; the pressure intensity within the chamber is maintained at 0.3 Pa; the sputtering power source is turned on, and the power density of the power source is 1.5 W/cm²; a fourth non-watered ITO layer (9') is deposited onto the second watered ITO transparent conductive layer (8') using the magnetron sputtering process;
h) a first electrode (10) and a second electrode (10') are respectively screen-printed on the third non-watered ITO layer (9) and the fourth non-watered ITO layer (9').

### Performance Test

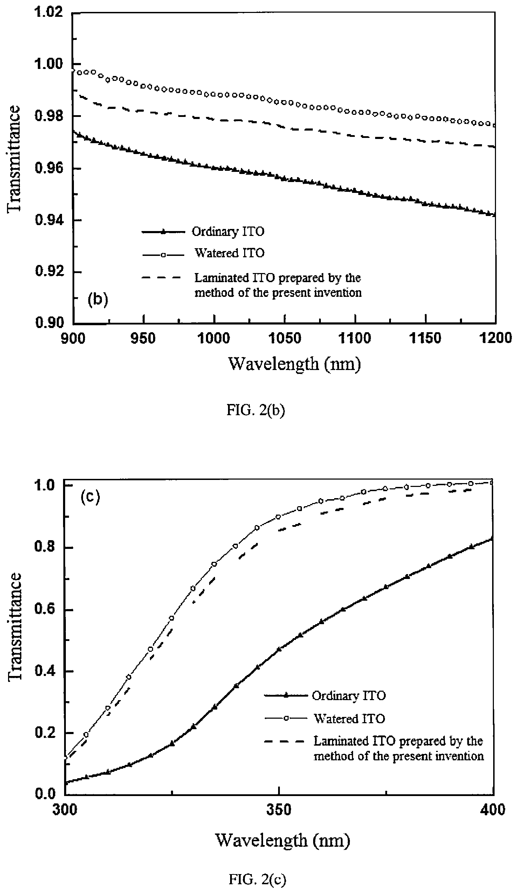

The transmittance spectra of ordinary ITO, watered ITO and laminated ITO prepared in Embodiment 1 are tested, and test results are as shown in Figures 2(a), 2(b) and 2(c). The transmittance of the laminated ITO composed of the first non-watered ITO layer (6), the first watered ITO transparent conductive layer (8) and the third non-watered ITO layer (9) is almost the same as that of the laminated ITO composed of the second non-watered ITO layer (7), the second watered ITO transparent conductive layer (8') and the fourth non-watered ITO layer (9'). Therefore, the laminated ITO prepared in Embodiment 1 refers to any one of the above laminated ITO.

As can be seen from Figures 2(a), 2(b) and 2(c), the transmittance of the laminated ITO film prepared in Embodiment 1 is significantly higher than that of the ordinary ITO material having the same thickness (a bigger number represents a better transmittance), and is basically comparable to that of the pure watered ITO having the same thickness. Moreover, this laminated ITO film is freed from the problem of poor contact with amorphous silicon and silver grids.

2. The efficiency of the heterojunction cell fabricated in Embodiment 1 of the present application and the cell fabricated by other single-structure ITO is tested, and test results are as shown in Table 1 (parameters have been normalized).

**Table 1**

| ITO Type | Efficiency | Open-circuit Voltage | Short-circuit Current | Filling Factor |
|---|---|---|---|---|
| Ordinary ITO | 100.00% | 100.00% | 100.00% | 100.00% |
| Watered ITO | 99.22% | 99.42% | 105.05% | 95.00% |
| Embodiment 1 | 105.25% | 100.57% | 104.71% | 99.95% |

As can be seen from Table 1, the efficiency of the heterojunction cell fabricated in Embodiment 1 of the present application is obviously superior to that of the cells fabricated by ordinary non-watered ITO films and watered ITO films, which is improved by more than 5%.

Although the embodiments disclosed by the present application have been described above, the described contents are merely the embodiments employed to facilitate understanding of the present application, and not intended to limit the present application. For any of those skilled in the art to which the present application relates, any modifications and changes may be made to the implementation forms and details without departing from the spirit and scope disclosed by the present application. However, the scope of patent protection of the present application shall be subject to the scope defined by the appending claims.

## Claims

1. A heterojunction solar cell, comprising:
a first electrode (10), a first watered transparent conductive layer (8), a first silicon doped layer (3), a first intrinsic silicon passivated layer (2), a silicon wafer (1), a second intrinsic silicon passivated layer (4), a second silicon doped layer (5), a second watered transparent conductive layer (8') and a second electrode (10') stacked successively.

2. The heterojunction solar cell according to claim 1, wherein the first silicon doped layer (3) is a first amorphous silicon doped layer; and,
the first intrinsic silicon passivated layer (2) is a first intrinsic amorphous silicon passivated layer; and,
the silicon wafer (1) is a monocrystalline silicon wafer; and,
the second intrinsic silicon passivated layer (4) is a second intrinsic amorphous silicon passivated layer; and,
the second silicon doped layer (5) is a second amorphous silicon doped layer.

3. The heterojunction solar cell according to claim 1 or 2, wherein the first watered transparent conductive layer (8) and the second watered transparent conductive layer (8') each have a thickness having a range from 50 nm to 110 nm.

4. The heterojunction solar cell according to anyone of claims 1 to 3, wherein the heterojunction solar cell further comprises a non-watered transparent conductive layer, the non-watered transparent conductive layer comprises a first non-watered layer (6) and a second non-watered layer (7);
the first non-watered layer (6) is disposed between the first silicon doped layer (3) and the first watered transparent conductive layer (8); and
the second non-watered layer (7) is disposed between the second silicon doped layer (5) and the second watered transparent conductive layer (8').

5. The heterojunction solar cell according to claim 4, wherein the non-watered transparent conductive layer further comprises a third non-watered layer (9) and a fourth non-watered layer (9');
the third non-watered layer (9) is disposed between the first watered transparent conductive layer (8) and the first electrode (10); and
the fourth non-watered layer (9') is disposed between the second watered transparent conductive layer (8') and the second electrode (10').

6. The heterojunction solar cell according to claim 4, wherein, a transparent conductive layer is selected from the group consisting of the first watered transparent conductive layer (8), the second watered transparent conductive layer (8') and the non-watered transparent conductive layer, and
the transparent conductive layer is an ITO transparent conductive layer or an AZO transparent conductive layer.

7. The heterojunction solar cell according to claim 4, wherein the first non-watered layer (6) and the second non-watered layer (7) each have a thickness having a range from 5nm to 10 nm.

8. The heterojunction solar cell according to claim 4, wherein the first non-watered layer (6) has a square resistance of 20Ω/□ to 80 Ω/□, and the second non-watered layer (7) has a square resistance of 130Ω/□ to 200 Q/□.

9. The heterojunction solar cell according to claim 5, wherein the third non-watered layer (9) and the fourth non-watered layer (9') each have a thickness having a range from 5nm to to 10 nm and a square resistance of 20Ω/□ to 80 Ω/□.

10. A method for fabricating a heterojunction solar cell, comprising:
sequentially depositing a first intrinsic silicon passivated layer (2) and a first silicon doped layer (3) onto a first surface of a silicon wafer (1), and sequentially depositing a second intrinsic silicon passivated layer (4) and a second silicon doped layer (5) onto a second surface of the silicon wafer (1);
depositing a first watered transparent conductive layer (8) onto the first silicon doped layer (3);
depositing a second watered transparent conductive layer (8) onto the second silicon doped layer (5); and
respectively forming a first electrode (10) and a second electrode (10') on the first watered transparent conductive layer (8) and the second watered transparent conductive layer (8').

11. The method for fabricating a heterojunction solar cell according to claim 10, wherein the first watered transparent conductive layer (8) is a first watered ITO transparent conductive layer; and,
the first silicon doped layer (3) is a first amorphous silicon doped layer; and,
the first intrinsic silicon passivated layer (4) is a first intrinsic amorphous silicon passivated layer;and,
the silicon wafer (1) is a monocrystalline silicon wafer; and,
the second intrinsic silicon passivated layer (4) is a second intrinsic amorphous silicon passivated layer; and,
the second silicon doped (5) layer is a second amorphous silicon doped layer; and,
the second watered transparent conductive layer (10') is a second watered ITO transparent conductive layer.

12. The method for fabricating a heterojunction solar cell according to claim 11, wherein,
after depositing the first amorphous silicon doped layer (3) onto the first intrinsic amorphous silicon passivated layer (4), and before depositing the first watered ITO transparent conductive layer (8) onto the first amorphous silicon doped layer, the method further comprises: depositing a first non-watered ITO layer (6) onto the first amorphous silicon doped layer (3), and then depositing the first watered ITO transparent conductive layer (8) onto the first non-watered ITO layer; and
after depositing the second amorphous silicon doped layer (5) onto the second intrinsic amorphous silicon passivated layer (4), and before depositing the second watered ITO transparent conductive layer (10') onto the second amorphous silicon doped layer (5), the method further comprises: depositing a second non-watered ITO layer onto the second amorphous silicon doped layer, and then depositing the second watered ITO transparent conductive layer onto the second non-watered ITO layer.

13. The method for fabricating a heterojunction solar cell according to claim 12, wherein,
after depositing the first watered ITO transparent conductive layer (8), and before screen-printing the first electrode (10), the method further comprises: depositing a third non-watered ITO layer (9) onto the first watered ITO transparent conductive layer (8), and then screen-printing the first electrode on the third non-watered ITO layer; and
after depositing the second watered ITO transparent conductive layer (8'), and before screen-printing the second electrode (10'), the method further comprises: depositing a fourth non-watered ITO layer (9') onto the second watered ITO transparent conductive layer, and then screen-printing the second electrode on the fourth non-watered ITO layer.

14. The method for fabricating a heterojunction solar cell according to claim 11, wherein the step of depositing the first watered ITO transparent conductive layer (8) or the second watered ITO transparent conductive layer (8') comprises: introducing argon, oxygen and water vapor at room temperature, and depositing the first watered ITO transparent conductive layer or the second watered ITO transparent conductive layer.

15. The method for fabricating a heterojunction solar cell according to claim 12, wherein the step of depositing the first non-watered ITO layer (6) onto the first amorphous silicon doped layer (3) comprises: introducing argon and oxygen at room temperature, and depositing the first non-watered ITO layer onto the first amorphous silicon doped layer using the magnetron sputtering process,
wherein
a gas flow ratio of the argon to the oxygen is 20:1 to 60:1; and,
a pressure is 0.1 Pa to 2 Pa during deposition, and a power density of a sputtering power source is 0.5 W/cm² to 3 W/cm²; and,
the first non-watered ITO layer has a thickness of 5 nm to 10 nm and a square resistance of 20Ω/□ to 80 Ω/□.
